# EUROPÄISCHE PATENTSCHRIFT

(11) **EP 0 675 368 B1**
(45) Veröffentlichungstag und Bekanntmachung des Hinweises auf die Patenterteilung: **28.08.2002**
(21) Anmeldenummer: 94810195.1
(22) Anmeldetag: 30.03.1994
(51) Int. Cl.: G01R 21/08

(54) **Eingangsteil eines Messgerätes**
Measuring instrument input circuit
Circuit d'entrée d'un appareil de mesure

(43) Veröffentlichungstag der Anmeldung: 04.10.1995
(73) Patentinhaber: Siemens Metering AG, 6300 Zug (CH)
(72) Erfinder: Thiébaud, Michel, CH-6332 Hagendorn (CH); Huber, Tony, CH-6300 Zug (CH); Haller, Hans-Peter, CH-6330 Cham (CH)
(74) Vertreter: Berg, Peter

(56) Entgegenhaltungen:
- EP-A- 0 578 948
- DE-U- 8 626 165
- FR-A- 2 647 908
- PATENT ABSTRACTS OF JAPAN vol. 8, no. 183 (P-296) (1620) 23. August 1984 & JP-A-59 075 158 (MITSUBISHI) 27. April 1984
- PATENT ABSTRACTS OF JAPAN vol. 6, no. 136 (E-120) (1014) 23. Juli 1982 & JP-A-57 062 510 (TOKYO SHIBAURA DENKI) 15. April 1982

## Beschreibung

Die Erfindung bezieht sich auf ein Eingangsteil eines Messgerätes gemäss dem Oberbegriff des Anspruchs 1.

Das Messgerät ist vorzugsweise ein Einphasen- oder Mehrphasen-Elektrizitätszähler oder Kombinations-Elektrizitätszähler. Im letzteren werden bekanntlich verschiedene Energiearten, wie z. B. Wirk-, Schein- und/oder Blindenergie, oder zusätzlich zu einer bestimmten Energieart noch ein zugehöriger Strom, dessen Effektivwert und/oder eine zugehörige Spannung gemessen. Das Messgerät kann auch ein Strom- und/oder Spannungs-Messgerät sein. Da im Eingangsteil eines Elektrizitätszählers immer auch eine zur Energie gehörende Leistung ermittelt wird, kann das Messgerät ebenfalls ein Leistungs-Messgerät sein.

Ein Eingangsteil der eingangs genannten Art ist aus der EP 0 578 948 A1 bekannt, in der jede Stromschlaufe mechanisch unabhängig von den anderen Stromschlaufen ist, eine eigene Leiterplatte besitzt und mit der letzteren sowie einem Sensorbaustein, einem rohrförmigen magnetischen Joch und einer das letztere fakultativ umgebenden magnetischen Abschirmung eine vergossene Baueinheit bildet, die kalibriert auf Lager gelegt werden kann, um gegebenenfalls später, z. B. im Austausch gegen eine defekte Baueinheit, in das Messgerät eingebaut zu werden. Das Joch ist entweder nicht oder nur unzureichend gegenüber der Stromschlaufe elektrisch isoliert, so dass es gut gegenüber dem im Sensorbaustein enthaltenen Messystem isoliert sein mus, was einer Miniaturisierung des Sensorbausteins entgegensteht.

Der Erfindung liegt die Aufgabe zugrunde, ein Eingangsteil der eingangs genannten Art so zu verbessern, dass es, falls erforderlich eine Mehrphasen-Anordnung bildet, die für eine unterschiedliche Anzahl Phasen beziehungsweise für unterschiedliche Phasenanordnungen, wie z. B. Vierleiter- oder Dreileiter-Anordnungen, kalibriert lagerfähig ist, so dass ein Eingangsteil im Messgerät ohne neue Kalibration leicht austauschbar ist, und dass auch Sensorbausteine ausgetauscht werden können, ohne dass die Kalibration der anderen Sensorbausteine beeinflusst wird. Weitere Vorteile sind, dass kein Vergiessen der Baueinheiten mehr erforderlich ist, die Herstellungstoleranzen keine Einfluss mehr auf die Messgenauigkeit besitzen, welche somit z. B. unabhängig von Herstellungsgenauigkeiten der U-Schlaufen von Strompfaden ist, und dass die Positionierung sowie Fixierung des Eingangsteils im Gehäuse des Messgerätes sowie die Positionierung aller Phasen unter sich äusserst einfach ist. Zusätzliche Vorteile sind, dass anstelle eines in einem Sensorbaustein enthaltenes Messystem eine zugehörige Stromschlaufe gegenüber einem magnetischen Joch elektrisch isoliert ist, was eine Miniaturisierung des Sensorbausteins sowie ein an Masse Legen des Jochs ermöglicht. Das Joch kann dann zusammen mit einer an Masse liegenden elektrischen Abschirmung einen Faraday-Käfig bilden.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:
- Fig. 1: einen schematische Darstellung eines Querschnitts eines bekannten Sensorbausteins und eines dazugehörigen magnetischen Keises mit magnetischer Abschirmung,
- Fig. 2: eine räumliche Darstellung eines Aufbaus einer ersten Baueinheit ohne Anschlussklemmen für eine externe Verdrahtung,
- Fig. 3: eine räumliche Darstellung eines Aufbaus einer zweiten Baueinheit,
- Fig. 4: eine Seitenansicht des Sensorbausteins,
- Fig. 5: eine räumliche Darstellung einer elektrischen Abschirmung des Sensorbausteins,
- Fig. 6: eine räumliche Darstellung eines Aufbaus einer Makro-Baueinheit,
- Fig. 7: eine räumliche Darstellung eines Ineinandergreifens eines Teils der zweiten Baueinheit in die erste Baueinheit,
- Fig. 8: eine Wiedergabe, unter Weglassung von Anschlussklemmen, des um 180° gedrehten, in der Fig. 7 dargestellten Aufbaus,
- Fig. 9: eine räumliche Darstellung eines Ineinandergreifens der elektrischen Abschirmung in einer äusseren doppelwandigen Abschirmung,
- Fig. 10: eine räumliche Darstellung eines Einbaus der Makro-Baueinheit in einem Gehäuse des Messgerätes und
- Fig. 11: eine Darstellung einer aus Runddraht bestehenden Mehrfachschlaufe.

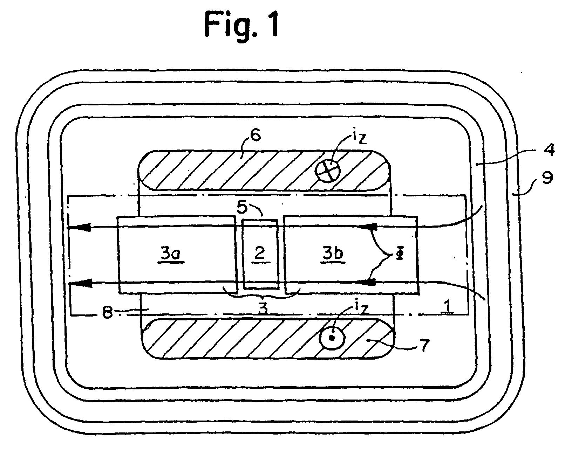

Das erfindungsgemässe Eingangsteil des Messgerätes enthält mindestens einen Sensorbaustein 1, der auf einer Leiterplatte angeordnet ist und einen an sich, z. B. aus der EP 0 578 948 A1, bekannten und in der Fig.. 1 dargestellten inneren Aufbau besitzt. Der Sensorbaustein 1 enthält jeweils einen Sensor 2 und einen Mittelsteg 3 eines ihm zugehörigen magnetischen Kreises 3;4. Der Mittelsteg 3 weist dabei mindestens einen Luftspalt 5 auf, in dem der zugehörige Sensor 2 angeordnet ist. Der letztere ist vorzugsweise ein Hallelement. Der Mittelsteg 3 besteht z. B. aus zwei magnetischen Plättchen 3a und 3b, zwischen denen sich der Luftspalt 5 befindet. Der Sensorbaustein 1 ist jeweils zwischen Leiterteilen 6 und 7 eines ihm zugehörigen Strompfades 8 angeordnet. Im Strompfad 8 fliesst im Betrieb ein elektrischer Strom i_{z}, der im Mittelsteg 3 einen Magnetfluss Φ erzeugt, der ebenfalls den Luftspalt 5 und damit den Sensor 2 durchquert. Der letztere wird von einem in der Fig. 1 nichtdargestellten Speisestrom gespeist. Das Ausgangssignal des Sensors 2 ist proportional dem Produkt dieses Speisestromes und des Stromes i_{z}.

Wenn der Speisestrom proportional einer zum Strom i_{z} gehörigen elektrischen Spannung u ist, dann ist das Ausgangssignal des Sensors 2 proportional einer Leistung u.i_{z}, welche mittels Integration, z. B. in einem Elektrizitätszähler, zur Ermittlung eines zugehörigen Energiewcrtes verwendet werden kann. Wenn der Speisestrom dagegen proportional i_{z} ist, dann ist das Ausgangssignal des Sensors 2 proportional i_{z}² und kann zur Ermittlung eines Effektivwertes des Stromes i_{z} benutzt werden. Wenn der Speisestrom ein konstanter Strom ist, dann ist das Ausgangssignal des Sensors 2 proportional i_{z} und kann zur Ermittlung des Wertes des Stromes i_{z} verwendet werden. Der Sensorbaustein 1 zusammen mit den Leiterteilen 6 und 7 sind mindestens teilweise von einem zugehörigen rohrförmigen magnetischen Joch 4 umgeben, welches zusammen mit dem Mittelsteg 3 den zugehörigen magnetischen Kreis 3;4 bildet. Der magnetische Kreis 3;4 besteht vorzugsweise aus MUMETALL. Eine zugehörige rohrförmige magnetische Abschirmung 9 ist nur fakultativ vorhanden. Sie umgibt ihrerseits, falls vorhanden, aussen koaxial jeweils das rohrförmige magnetische Joch 4, um mit diesem eine doppelwandige Abschirmung 4;9 zu bilden, dessen inneres Teil, also das Joch 4, gleichzeitig ein Teil des magnetischen Kreises 3;4 ist. Die magnetische Abschirmung 9 besteht vorzugsweise aus verzinktem Stahlblech. Die Selbstschirmung des magnetischen Kreises 3;4 gegen magnetische Wechselfelder, vor allem gegen ein Brummfeld der Netzfrequenz, ist auch ohne Abschirmung 9 genügend gross. Die Abschirmung 9 hat als Aufgabe, starke Gleich-Magnetfelder vom Joch 4 fernzuhalten, die vor allem bei Betrugsversuchen mit z. B. einem Permanentmagnet angelegt werden. Ohne Abschirmung 9 könnte das magnetische Joch 4 in die Sättigung gebracht werden. In der Sättigung ist die magnetische Leitfähigkeit des Jochs 4 kaum grösser als die Leitfähigkeit der Luft und der magnetische Nutzfluss nicht mehr im Joch 4 konzentriert. Die Folge ist eine Reduktion des Übertragungsfaktors der Anordnung und damit des gemessenen Energieverbrauchs sowie des verrechenbaren Preises auf ungefähr die Hälfte. Die Widerstandsfähigkeit gegen starke Gleich-Magnetfelder kann auch durch eine grössere Materialdicke des Jochs 4 erreicht werden, aber wegen der sehr hohen Materialkosten des MUMETALL's ist diese Lösung weniger günstig.

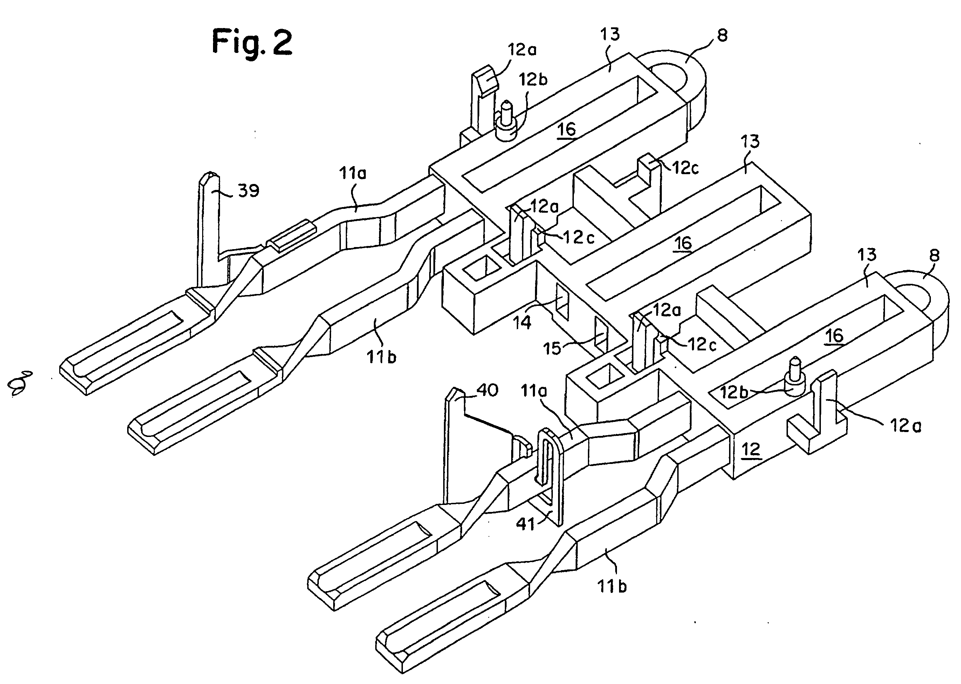

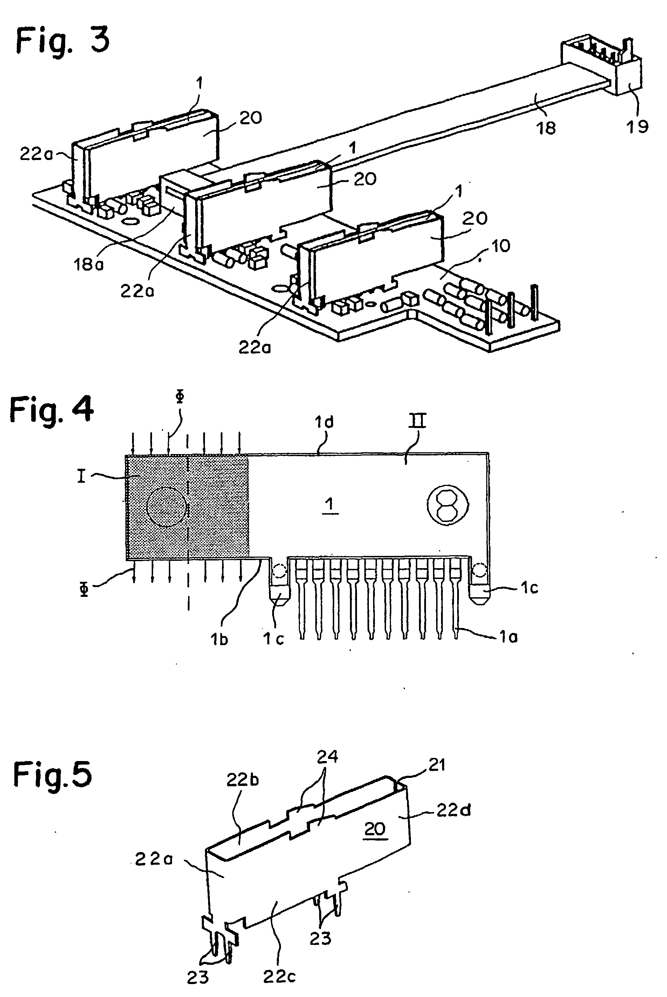

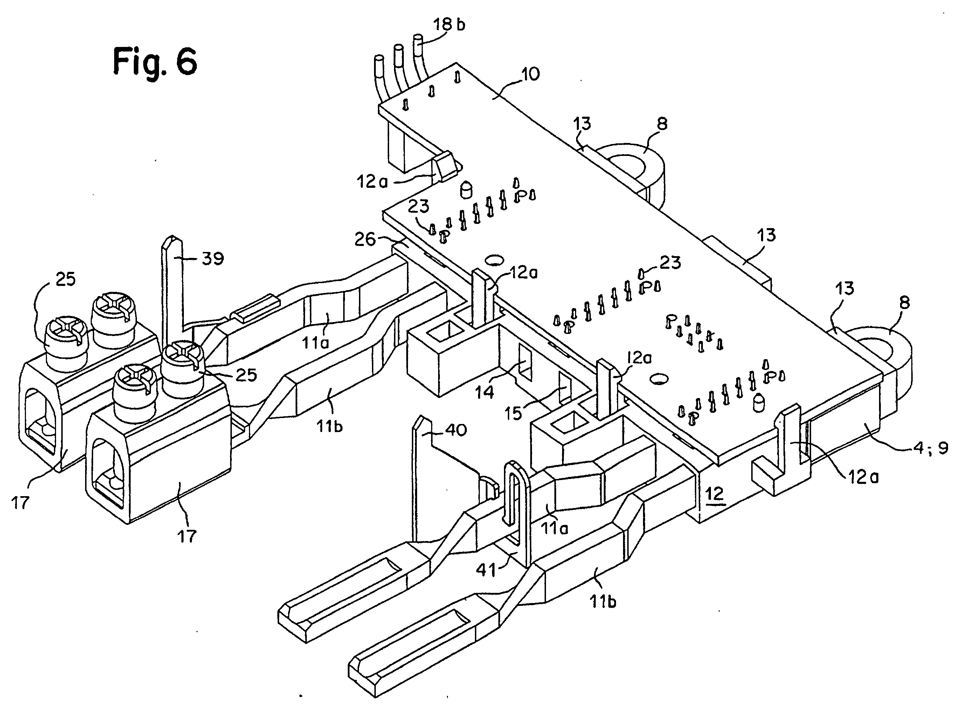

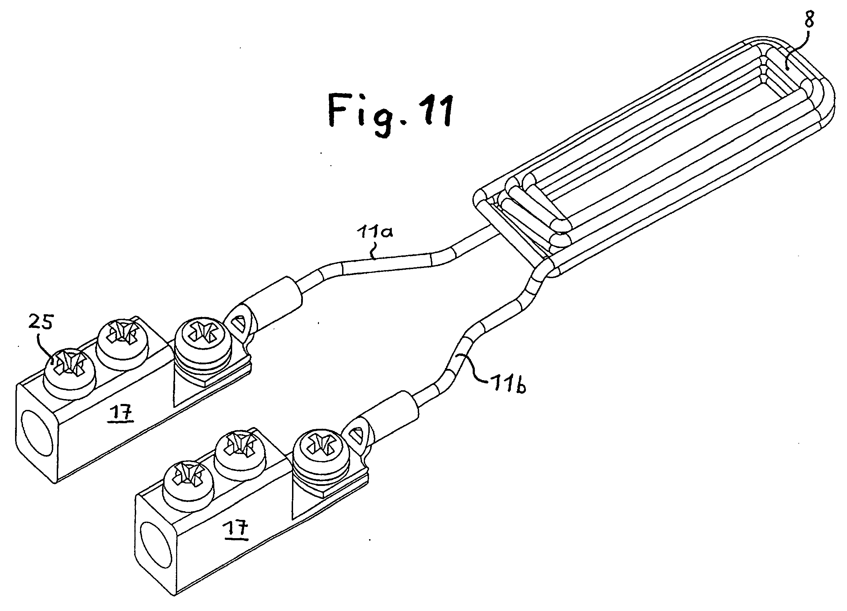

Das erfindungsgemässe Eingangsteil ist vorzugsweise für eine maximale Anzahl, z. B. 1, oder 3, von Strompfaden 8 beziehungsweise, da zu jedem Stromfad 8 mindestens ein Sensorbaustein 1 gehört, von Sensorbausteinen 1 ausgelegt. Falls mehrere Sensorbausteine 1 vorhanden sind, sind diese vorzugsweise alle auf einer einzigen Leiterplatte 10 angeordnet (Siehe Fig. 3). Die Strompfade 8 bilden jeweils eine aus Kupferprofil bestehende Einfachschlaufe oder eine aus Profildraht oder Runddraht bestehende Mehrfachschlaufe (siehe Fig. 11). In der Fig. 2, Fig. 6, Fig. 7, Fig. 8 und Fig. 10 gilt jeweils die Annahme, dass die Strompfade 8 je eine U-förmige Einfach-Stromschlaufe bilden, die jeweils einen Hinleiter 11a und einen Rückleiter 11b aufweist (Siehe Fig. 2). Die Leiterteile 6 und 7 bestehen dann jeweils aus einem Teil des Hinleiters 11a bzw. des Rückleiters 11b. Die beiden letzteren besitzen z. B. je einen rechteckförmigen Querschnitt. Das U-förmige Teil der Strompfade 8 kann jedoch auch, was in den Figuren nicht dargestellt ist, die Gestalt einer Wicklung besitzen, die N Windungen aufweist, so dass die Leiterteile 6 und 7 des zugehörigen Strompfades 8 jeweils aus N parallelen Teilen des Hinleiters 11a bzw. aus N parallelen Teilen des Rückleiters 11b bestehen. Ein Kunststoff-Träger 12 besitzt pro möglichen Strompfad 8 einen Steg 13, welcher jeweils sowohl zwei kanalförmige Durchgänge 14 und 15 für die Leiterteile 6 bzw. 7 des betreffenden Strompfades 8 als auch eine Aussparung 16 für den zum betreffenden Strompfad 8 gehörigen Sensorbaustein 1 aufweist. Die Aussparung 16 ist, senkrecht zu den beiden kanalförmigen Durchgängen 14 und 15 des betreffenden Strompfades 8 verlaufend, zwischen diesen Durchgängen 14 und 15 im zugehörigen Steg 13 angeordnet. Der Kunststoff-Träger 12 ist vorzugsweise ein Spritzteil, welches um Teile der Strompfade 8 gespritzt ist. Der Steg 13 des Kunststoff-Trägers 12, das rohrförmige magnetische Joch 4 und die rohrförmige magnetische Abschirmung 9 besitzen vorzugsweise, und nachfolgend gilt die Annahme, dass dies wirklich der Fall ist, jeweils einen rechteckförmigen Querschnitt. Der Kunststoff-Träger 12 und die Leiterplatte 10 sind für die erwähnte maximale Anzahl von Strompfaden 8 beziehungsweise Sensorbausteinen 1 ausgelegt. In der Fig. 2 gilt die Annahme, dass maximal drei Strompfade 8 bzw. maximal drei Sensorbausteine 1 vorhanden sind. Bei einem Dreiphasen-Elektrizitätszähler in 4-Leiter-Anordnung sind alle drei Strompfade 8 und alle drei Sensorbausteine 1 vorhanden und damit alle drei Stege 13 des Kunststoff-Trägers 12 mit je einem Strompfad 8 und je einem Sensorbaustein 1 belegt. Wenn die erwähnte maximale Anzahl grösscr als Eins ist und wenn weniger Sensorbausteine 1 und damit auch weniger Strompfade 8 als die maximale Anzahl zur Realisierung des Messgerätes erforderlich sind, dann sind die zu den nicht benötigten Sensorbausteinen 1 gehörigen Montageorte der Leiterplatte 10 leer. Bei einem Dreiphasen-Elektrizitätszähler in 3-Leiter-Anordnung sind z. B. nur je zwei Sensorbausteine 1 vorhanden und es werden demnach an sich nur je zwei Strompfade 8 benötigt, so dass z. B. der mittlere Steg 13 des mit drei Stegen 13 versehenen Kunststoff-Trägers 12, wie in der Fig. 2 dargestellt, theoretisch leer sein könnte. Ähnliches gilt auch für einen Einphasen-Elektrizitätszähler, in dem nur ein einziger Steg 13 belegt sein muss und die beiden anderen Stege 13 des mit drei Stegen 13 versehenen Kunststoff-Trägers 12 theoretisch leer sein könnten. In der Praxis sind trotzdem jedoch, wenn weniger Strompfade 8 und damit auch weniger Sensorbausteine 1 als die maximale Anzahl zur Realisierung des Messgerätes erforderlich sind, die Durchgänge 14 und 15 aller Stege 13 des Kunststoffträgers 12 mit je einem Strompfad 8 belegt, damit der Kunststoff-Träger 12 als Spritzteil hergestellt werden kann. Somit sind die zu den nicht benötigten Strompfaden 8 gehörigen Durchgänge 14 und 15 mit je einem nicht benötigten Strompfad 8 belegt. Die für die Messung nicht erforderlichen Strompfade 8 sind aussen mit mindestens einem der benötigten Strompfade 8 elektrisch in Reihe geschaltet und laufen somit im Leerlauf mit, da die zugehörigen Sensorbausteine 1 jeweils fehlen. Der Kunststoff-Träger 12 und alle Strompfade 8 bilden zusammen eine erste Baueinheit, in der noch Anschlussklemmen 17 (Siehe Fig. 6) zum Anschluss einer externen Verdrahtung an die Strompfade 8 fehlen.

Die Leiterplatte 10 bildet mit ihrer Bestückung eine zweite Baueinheit, die in der Fig. 3 dargestellt ist, wo das Vorhandensein dreier Sensorbausteine 1 angenommen wurde. Die letzteren sind parallel zueinander auf der Leiterplatte 10 angeordnet. Auf derselben sind ausserdem noch elektronische Bauelemente montiert, die zum Betrieb der Sensoren 2 erforderlich sind, sowie elektronische Bauelemente einer dem zugehörigen Sensor 2 jeweils nachgeschalteten Signalverarbeitung. Ein mehrere Drähte aufweisendes Kabel, z. B. ein Flachbandkabel 18, dient der elektrischen Verbindung der Leiterplatte 10 zu mindestens einer weiteren, nicht dargestellten Leiterplatte, die im Gehäuse des Messgerätes angeordnet ist und auf der weitere elektronische Bauelemente des Messgerätes montiert sind. Das Flachbandkabel 18 besitzt z. B. an einem seiner beiden Enden eine mehrpolige Buchse 18a, die in Steckkontakte der Leiterplatte 10 gesteckt ist, und an seinem anderen Ende einen mehrpoligen Stecker 19, der in einer mehrpoligen Buchse der weiteren Leiterplatte steckbar ist. Anstelle der Steckkontakte und der Buchse 18a kann das Flachbandkabel 18 auch unmittelbar mittels Lötungen an die Leiterplatte 10 angeschlossen sein.

Die Sensorbausteine 1 haben eine plättchenförmige Gestalt. Wie aus der Fig. 4 ersichtlich besitzen sie zur Montage auf die Leiterplatte 10 lötbare Anschlussbeine 1a, die entlang nur eines Teils einer unteren Schmalseite 1b des Sensorbausteins 1 angeordnet sind. Die neuartige Anordnung der Anschlussbeine 1a ausschliesslich an der unteren Schmalseite 1b des Sensorbausteins 1 gestattet eine einfachere "Umwicklung" des letzteren mit einer oder mehreren Stromschlaufen des zugehörigen Strompfades 8. Dies ist besonders vorteilhaft bei der Verwendung von Mehrfach-Stromschlaufen. Das in der Darstellung der Fig. 4 linke, schraffierte Teil I des Sensorbaustcins 1 besitzt keine Anschlussbeine 1a und enthält mindestens alle elektromagnetisch empfindliche Teile sowie den Mittelsteg 3 und den Sensor 2 des betreffenden Sensorbausteins 1. Die restlichen Bauelemente des Sensorbausteins 1 sowie die Anschlussverbindungen der Anschlussbeine 1a sind in einem nichtschraffierten, rechten Teil II des Sensorbausteins 1 angeordnet, welches an seiner unteren Schmalseite 1b alle Anschlussbeine 1a sowie kleine Distanzstifte 1c aufweist. Nach dem Montieren des Eingangsteils ist nur das Teil I des Sensorbausteins 1 vom magnetischen Joch 4 und, falls vorhanden, von der magnetischen Abschirmung 9 umgeben, so dass nur das Teil I dem vom Strom iₛ erzeugten Magnetfluss Φ ausgesetzt ist. Der letztere dringt z. B. durch eine obere Schmalseite 1d in das Teil I des Sensorbausteins 1 ein und verlässt es wieder durch die untere Schmalseite 1b, welche, wie bereits erwähnt, keine Anschlussbeine 1a aufweist. Dank der Distanzstifte 1c entsteht nach der Montage des Sensorbausteins 1 auf die Leiterplatte 10 zwischen dieser und dem Teil I des Sensorbausteins 1 ein Leerraum, der genügend Raum bietet zur Aufnahme derjenigen Seite des Jochs 4 und ggf. der Abschirmung 9, die zwischen dem Sensorbaustein 1 und der Leiterplatte 10 zu liegen kommt, wenn das Joch 4 und ggf. die Abschirmung 9 über den zugehörigen Steg 13 und damit über den Sensorbaustein 1 geschoben werden.

Der Sensorbaustein 1 ist in vorteilhafter Weise seitlich jeweils von einer zugehörigen, über die Leiterplatte 10 an Masse liegenden elektrischen Abschirmung 20, d. h. einer Abschirmung gegen elektrische Felder umgeben (Siehe Fig. 3). Eine interne Abschirmung innerhalb des Sensorbaustein-Gehäuses durch Aufbringen einer Leitlack-Schicht erübrigt sich in diesem Fall. Die elektrische Abschirmung 20 besteht vorzugsweise aus nichtferromagnetischem Material, z. B. aus Bronze, um die Funktion des magnetischen Kreises 3;4 nicht zu stören. Zur Vermeidung einer Beeinflussung der Wechselstrom-Magnetfelder durch Wirbelströme ist die elektrische Abschirmung 20 vorzugsweise rohrförmig, d. h. unten sowie oben offen, und weist, z. B. parallel zu ihrer Rohrachse, jeweils einen schmalen schlitzförmigen Luftspalt 21 auf, da sich die elektrische Abschirmung 20 ansonsten wie eine Kurzschlusswindung eines Transformators verhalten würde. Sie ist, trotz ihrer Öffnungen nach oben und unten, als elektrische Abschirmung ausreichend wirksam, da sie, genau wie das Joch 4, auf das Bezugspotential des in den Sensorbausteinen 1 enthaltenen elektronischen Messystems, d. h. an Masse liegt und damit den fehlenden Teil der durch das Joch 4 gebildeten elektrischen Abschirmung, d. h. den fehlenden Teil eines Faraday-Käfigs bildet. Dies ist nur möglich dank der Tatsache, dass die auf eine relativ hohe Spannung von 220 V liegende Strompfade 8 durch den eine Stoss-Spannung von mindestens 2kV aushaltenden Kunststoff-Träger 12 gegen das Joch 4 isoliert sind oder, mit anderen Worten, dass jeder Strompfad 8 und nicht, wie im Stand der Technik, das elektronische Messystem gegenüber dem Joch 4 isoliert ist. Letzteres hat ausserdem den Vorteil, dass die Sensorbausteine 1 und deren Anschlussbein-Abstände bedeutend kleiner, z. B. halb so gross sein können wie im Stand der Technik, was einer Miniaturisierung der Sensorbausteine 1 sehr entgegenkommt. Die elektrische Abschirmung 20 besitzt vorzugsweise., wie in der Fig. 5 dargestellt, einen rechteckförmigen Querschnitt und ist jeweils der äusseren seitlichen Gestalt des zugehörigen Sensorbausteins 1 angepasst. Sie besteht z. B. jeweils aus einem rohrförmig gebogenen Blech und weist z. B. an einer ihren Schmalseiten 22a sowie an zwei ihrer Längsseiten 22b und 22c, Lötfahnen 23 auf zwecks ihrer Montage auf die Leiterplatte 10, wo sie gelötet in zugehörigen Bohrlöchern so angeordnet ist, dass sie den zugehörigen Sensorbaustein 1 seitlich umgibt. Der schlitzförmige Luftspalt 21 ist vorzugsweise in einer der Schmalseite 22a gegenüberliegende Schmalseite 22d angeordnet. Die beiden gegenüberliegenden Längsseiten 22b und 22c der elektrischen Abschirmungen 20 weisen jeweils an ihren von der Leiterplatte 10 abgewandten Kanten je eine sägezahnförmige Ausbuchtung 24 auf zum Einrasten der magnetischen Abschirmung 9 oder, falls diese fehlt, des Jochs 4.

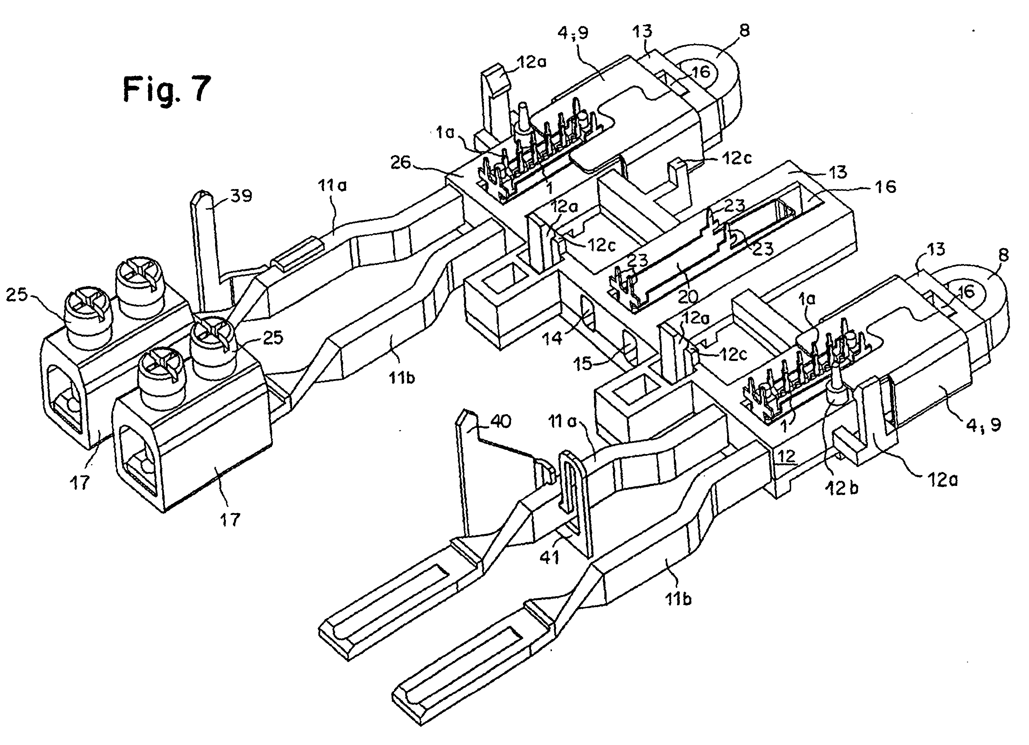

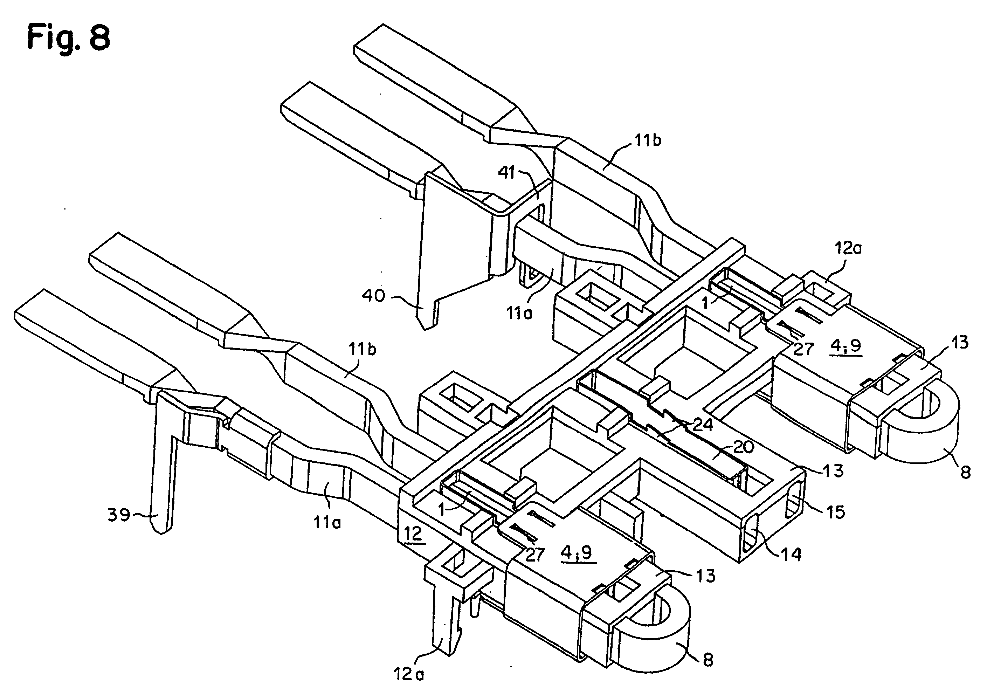

In der Fig. 6, Fig. 7 und Fig. 8 ist ein Zusammenbau der ersten und der zweiten Baueinheit zu einer Makro-Baueinheit dargestellt, wobei in der Fig. 7 und Fig. 8 aus Gründen der zeichnerischen Einfachheit und unter Belassung der Sensorbausteine 1, der doppelwandigen Abschirmungen 4;9 und der Abschirmungen 20 in ihrer nach der Montage der Makrobaueinheit eingenommenen Positionen die gemeinsame Leiterplatte 10 weggelassen wurde, was einem fiktiven Zwischenzustand der Montage entspricht, der in der Praxis niemals eintritt, da die Sensorbausteine 1 und die Abschirmungen 20 bereits vor der Montage immer fest auf der Leiterplatte 10 montiert sind und die doppelwandigen Abschirmungen 4;9 erst nach Vorhandensein der Leiterplatte 10 montiert werden. Die Fig. 8 stellt unter Weglassung der Anschlussklemmen 17 und ihren Befestigungen die Rückseite der in der Fig. 7 dargestellten Anordnung dar. In den Figuren 6 bis 8 ist der mittlere Steg 13 des Kunststoff-Trägers 12 aus Gründen der zeichnerischen Klarheit mit keinem Strompfad 8 belegt, obwohl dieser vorhanden ist.

Die bereits erwähnten Anschlussklemmen 17 sind je mittels zweier Schrauben 25 auf den beiden Enden der vorhandenen Strompfade 8 befestigt. Die Makro-Baueinheit besteht, einmal von den doppelwandigen Abschirmungen 4;9, d. h. von den rohrförmigen Jochen 4 und den rohrförmigen Abschirmungen 9 abgesehen, aus der mit den Anschlussklemmen 17 und den Schrauben 25 versehenen ersten Baueinheit und aus der zweiten Baueinheit. Der Kunstoff-Träger 12 weist eine Anordnung 12a;12b;12c zum Aufschnappen und zur Auflage der einzigen Leiterplatte 10 auf. Zu diesem Zweck besitzt er z. B. Aufschnappfedern 12a sowie Distanzbolzen 12b und Distanzstege 12c (Siehe Fig. 2), die letzteren zur Auflage der Leiterplatte 10 nach deren Aufschnappen. Die einzige Leiterplatte 10 ist somit nach ihrem Aufschnappen mitsamt ihrer Bestückung auf den Distanzbolzen 12b und den Distanzstegen 12c aufliegend auf den Kunststoff-Träger 12 parallel zu einer Fläche 26 desselben angeordnet. Dies erfolgt dermassen, dass der vorhandene Sensorbaustein 1 mit der ihm umgebenden elektrischen Abschirmung 20 jeweils in der ihm zugehörigen Aussparung 16 liegt. Da in der Darstellung der Zeichnung der erste Baustein unter die Leiterplatte 10 angeordnet und die Bestückungsseite der letzteren dem ersten Baustein zugewandt ist, hängt dort der Sensorbaustein 1 mitsamt seiner Abschirmung 20 in der ihm zugehörigen Aussparung 16.

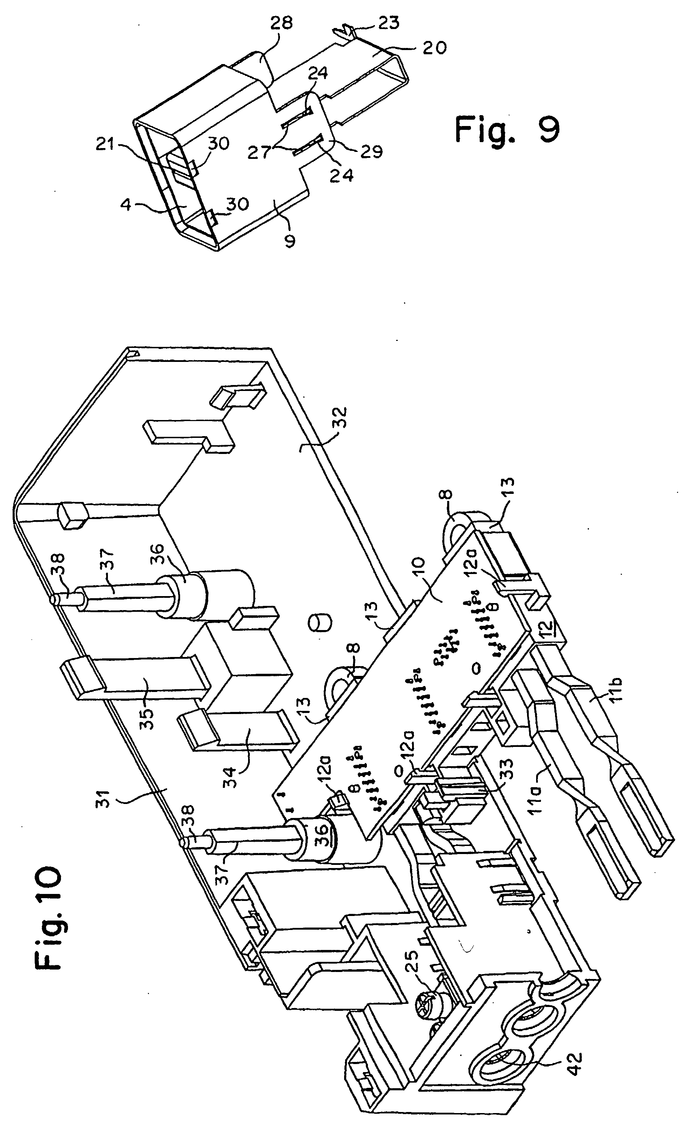

Nach der Montage der zweiten auf die erste Baueinheit werden die rohrförmigen Joche 4 und, falls vorhanden, die sie jeweils umgebenden rohrförmigen magnetischen Abschirmungen 9 im Makro-Baustein jeweils aussen über den ihnen zugehörigen Steg 13 geschoben, bis dass zwei Schlitze 27 der Abschirmung 9 in die beiden sägezahnförmigen Ausbuchtungen 24 der zugehörigen elektrischen Abschirmung 20 einrasten. Das rohrförmige magnetische Joch 4 ist somit in die rohrförmige magnetische Abschirmung 9 gesteckt und in seiner Endposition auf der elektrischen Abschirmung 20 zentriert und eingerastet angeordnet. Die Joche 4 sind dabei jeweils in elektrischem Kontakt mit der zugehörigen Abschirmung 20. Da die letztere über die Leiterplatte 10 jeweils an Masse liegt, liegen die Joche 4 nicht, wie im Stand der Technik, auf dem Potential der Strompfade 8, sondern ebenfalls an Masse und damit auf dem Bezugspotential des Mess-Systems. Dies ist einfacher zu realisieren und bietet Vorteile bezüglich der elektromagnetischen Verträglichkeit EMV, da ein zusätzlicher Abschirmeffekt durch die an Masse liegenden Joche 4 zustande kommt. In der Fig. 9 ist das Ineinandergreifen der Abschirmung 20 in die doppelwandige Abschirmung 4;9 dargestellt. Aus Gründen der zeichnerischen Einfachheit wurden der zugehörige Sensorbaustein 1 und die Leiterplatte 10 weggelassen, obwohl der erstere immer in die Abschirmung 20 und die Abschirmung 20 immer auf der Leiterplatte 10 angeordnet ist, bevor das rohrförmige magnetische Joch 4 und, falls vorhanden, die sie umgebende rohrförmige magnetische Abschirmung 9 aussen jeweils über den zugehörigen Steg 13 und damit über einen Teil der Abschirmung 20 und des dazugehörigen Sensorbausteins 1 geschoben wird. Das Joch 4 und die Abschirmung 9 sind beide annähernd gleich gross, nur besitzt die letztere an zwei gegenüberliegenden Seiten jeweils über das Joch 4 lappenförmig hinausragende vorstehende Ausbuchtungen 28 und 29. Wenn die Abschirmung 9 fehlt, besitzt dagegen das Joch 4 mit allen nachfolgend beschriebenen Details die erwähnte Gestalt und Abmessung der Abschirmung 9. Die Schlitze 27 sind zueinander parallel in der Ausbuchtung 29 angeordnet. Auf die von den Ausbuchtungen 28 und 29 abgewandten Seiten des von der Abschirmung 9 gebildeten Rohres besitzt die letztere einige Einkerbungen 30, die bei der Montage verhindern, dass das Joch 4 durch die Abschirmung 9 hindurchfällt. Die Ausbuchtung 28 ist durch einen breiten Schlitz, der in der Fig. 9 nicht erkennbar ist, in zwei annähernd gleich grosse vorstehende Teilausbuchtungen unterteilt. Dadurch entsteht in der Ausbuchtung 28 freier Raum für die Anschlussbeine 1a des zugehörigen Sensorbausteins 1, die nach der Montage in diesem breiten Schlitz zu liegen kommen. In ihrer Endposition sind mindestens die elektromagnetisch empfindliche Teile sowie der Mittelsteg 3 und der Sensor 2 des zugehörigen Sensorbausteins 1 seitlich vom Joch 4 und ggf. von der Abschirmung 9 umgeben. Dabei liegt das rohrförmige magnetische Joch 4 und, falls vorhanden, die rohrförmige magnetische Abschirmung 9 jeweils teilweise zwischen der Leiterplatte 10 und dem Kunststoff-Träger 12. Das rohrförmige magnetische Joch 4 und/oder die rohrförmige magnetische Abschirmung 9 bestehen vorzugsweise jeweils aus einem rohrförmig gebogenen Blech, dessen Stosskanten vorzugsweise schwalbenschwanzförmig ineinandergreifen, um eine meanderförmige Nahtstelle zu bilden, wodurch Platz gespart wird, da die Bleche keine Überlappungen benötigen zur Bildung einer tragfähigen rohrförmigen Gestalt. Das magnetische Joch 4 zusammen mit der Abschirmung 20 bilden im Bereich des Teils I des Sensorbausteins 1 für diesen eine EMV-wirksame Anordnung.

Aus der Fig. 10 ist die relative Lage des Makro-Bausteins in einem Gehäuse 31 des Messgerätes ersichtlich. Der Makro-Baustein ist abgeglichen auf einen Boden 32 des dosenförmigen Gehäuses 31, z. B. aufgeschnappt, angeordnet. Der Boden 32 besitzt in der Fig. 10 nicht erkennbare waffelförmige Ausbuchtungen zur Aufnahme und Positionierung von Teilen des Kunststoff-Trägers 12 bei der Montage des Makro-Bausteins in das Gehäuse 31. Der Boden 32 weist ausserdem Aufschnappfedern 33, 34 und35 sowie Distanzbolzen 36 und 37 auf, die senkrecht zur Bodenfläche verlaufend in das Gehäuse 31 hineinragen und unterschiedliche Längen besitzen. Die Distanzbolzen 36 bestehen z. B. jeweils aus einem unteren Teil und die Distanzbolzen 37 jeweils aus einem mittleren Teil eines gemeinsamen Bolzens 36;37;38, dessen oberer Teil 38 jeweils einen kleineren Durchmesser als der mittlere Teil und der letztere jeweils einen kleineren Durchmesser als der untere Teil besitzt. Die Aufschnappfedern 33 dienen zum Befestigen des Makro-Bausteins auf den Boden 32 des Gehäuses 31, wobei dann die Leiterplatte 10 parallel zum Boden 32 angeordnet ist. Die annähernd gleich langen Aufschnappfedern 34 und Distanzbolzen 36 dienen zum Aufschnappen bzw. zur Auflage der bereits erwähnten und in der Fig. 10 nicht dargestellten weiteren Leiterplatte. Falls total zwei weitere Leiterplatten vorhanden sind, dienen die annähernd gleich langen Aufschnappfedern 35 und Distanzbolzen 37 zum Aufschnappen bzw. zur Auflage der zweiten weiteren Leiterplatte. Alle Leiterplatten sind dabei parallel zum Boden 32 des Gehäuses 31 angeordnet. Die elektrischen Verbindungen zwischen der Leiterplatte 10 und den anderen Leiterplatten erfolgt mittels des Flachbandkabels 18 (Siehe Fig. 3), weiterer Drahtverbindungen 18b (Siehe Fig. 6) sowie mittels je eines Kontaktstiftes 39 oder 40 pro Strompfad 8 (Siehe Fig. 2). Die Kontaktstifte 39 und 40 sind jeweils auf einem Leiter, z. B. 11a, ihres Strompfades 8 geschweisst oder genietet bzw. dort mittels je eines Einlegeteils 41 aufgeklemmt. Gegenüberliegend der Anschlussklemmen 17 besitzt das Gehäuse 31 in seiner Seitenwand mindestens eine Öffnung 42 pro Anschlussklemme 17 für den Durchgang einer externen Verdrahtung, die an der zugehörigen Anschlussklemme 17 und damit an dem dazugehörigen Strompfad 8 anzuschliessen ist.

Die Gesamt-Montage des Messgerätes erfolgt somit mittels folgender Montage-Schritte:
- Zuerst werden die benötigten Strompfade 8 mit dem Kunststoff-Träger 12 umspritzt und zwecks Bildung der ersten Baueinheit mit den Anschlussklemmen 17 versehen.
- Dann wird die bestückte Leiterplatte 10 auf die erste Baueinheit aufgeschnappt.
- Anschliessend werden die doppelwandigen Abschirmungen 4;9 bzw. die Joche 4 bis zum Einrasten in die sägezahnförmigen Ausbuchtungen 24 über den ihnen zugehörigen Steg 13 des Kunststoff-Trägers 12 geschoben.
- Die so entstandene Makro-Baueinheit wird dann elektrisch abgeglichen und nach dem Abgleich auf den Boden 32 des Gehäuses 31 aufgeschnappt.
- Schliesslich werden noch, eine nach der anderen, die weiteren Leiterplatten oberhalb des Makro-Bausteins und parallel zu der Leiterplatte 10 in das Gehäuse 31 aufgeschnappt angeordnet.

Der in der Fig. 11 als Mehrfachschlaufe aus Runddraht dargestellte Strompfad 8 besteht aus mehreren annähernd parallelen Windungen und kann somit preisgünstig hergestellt werden mittels Biegevorgänge um eine einzige Achse, die senkrecht zu den Windungsebenen verläuft. Die Windungsebenen sind vorzugsweise auch annähernd parallel zum Hinleiter 11a und zum Rückleiter 11b der Mehrfachschlaufe, während die Achse der letzteren nach der Montage jeweils annähernd parallel zu den Achsen der Aussparungen 16 des Kunststoff-Trägers 12 angeordnet ist.

## Patentansprüche

1. Eingangsteil eines Messgerätes mit mindestens einem auf einer Leiterplatte (10) angeordneten Sensorbaustein (1), der jeweils zwischen Leiterteilen (6, 7) eines zugehörigen Strompfades (8) angeordnet ist, wobei der Sensorbaustein (1) zusammen mit den Leiterteilen (6,7) mindestens teilweise von einem zugehörigen rohrförmigen magnetischen Joch (4) umgeben sind, welches Joche und äussere Schenkel eines zugehörigen magnetischen Kreises (3;4) bildet und seinerseits fakultativ jeweils von einer zugehörigen rohrförmigen magnetischen Abschirmung (9) umgeben ist, während ein Mittelsteg (3) des magnetischen Kreises (3;4) jeweils im zugehörigen Sensorbaustein (1) enthalten ist und mindestens einen Luftspalt (5) aufweist, in dem ein zugehöriger Sensor (2) angeordnet ist, **dadurch gekennzeichnet, dass** ein Kunststoff-Träger (12) pro Strompfad (8) einen Steg (13) besitzt, der sowohl zwei kanalförmige Durchgänge (14, 15) für die Leiterteile (6 bzw. 7) des betreffenden Strompfades (8) als auch eine Aussparung (16) für den zum betreffenden Strompfad (8) gehörigen Sensorbaustein (1) aufweist, die, senkrecht zu den beiden kanalförmigen Durchgängen (14, 15) verlaufend, zwischen den letzteren im zugehörigen Steg (13) angeordnet ist, dass der Kunststoff-Träger (12) und mindestens ein die kanalförmigen Durchgänge (14, 15) des zugehörigen Stegs (13) durchquerender Strompfad (8) eine Baueinheit bilden, dass die Leiterplatte (10) so angeordnet ist, dass der Sensorbaustein (1) jeweils in der ihm zugehörigen Aussparung (16) liegt, dass das rohrförmige magnetische Joch (4) und, falls vorhanden, die sie jeweils umgebende rohrförmige magnetische Abschirmung (9) aussen jeweils über den zugehörigen Steg (13) so parallel zu den kanalförmigen Durchgängen (14,15) geschoben sind, dass sie mindestens elektromagnetisch empfindliche Teile sowie den Mittelsteg (3) und den Sensor (2) des zugehörigen Sensorbausteins (1) seitlich umgeben, wobei das rohrförmige magnetische Joch (4) und, falls vorhanden, die rohrförmige magnetische Abschirmung (9) jeweils teilweise zwischen der Leiterplatte (10) und dem Kunststoff-Träger (12) liegen.

2. Eingangsteil nach Anspruch 1, **dadurch gekennzeichnet, dass**, falls mehrere Sensorbausteine (1) vorhanden sind, diese auf einer einzigen Leiterplatte (10) angeordnet sind und der Kunstoff-Träger (12) eine solche Anordnung (12a;12b;12c) zum Aufschnappen und zur Auflage der einzigen Leiterplatte (10) aufweist, dass die letztere nach ihrem Aufschnappen auf den Kunststoff-Träger (12) parallel zu einer Fläche (26) desselben angeordnet ist.

3. Eingangsteil nach Anspruch 1 oder 2, **dadurch gekennzeichnet, dass** der Kunststoff-Träger (12) und die Leiterplatte (10) für eine maximale Anzahl von Strompfaden (8) beziehungsweise Sensorbausteinen (1) ausgelegt sind und dass, wenn weniger Strompfade (8) und damit auch weniger Sensorbausteine (1) als die maximale Anzahl zur Realisierung des Messgerätes erforderlich sind, die zu den nicht benötigten Strompfaden (8) gehörigen Durchgänge (14, 15) des Kunststoff-Trägers (12) trotzdem mit je einem nicht benötigten Strompfad (8) belegt sind sowie die zu den nicht benötigten Sensorbausteinen (1) gehörigen Montageorte der Leiterplatte (10) leer sind.

4. Eingangsteil nach einem der Ansprüche 1 bis 3, **dadurch gekennzeichnet, dass** der Sensorbaustein (1) seitlich jeweils von einer zugehörigen elektrischen Abschirmung (20) umgeben ist.

5. Eingangsteil nach Anspruch 4, **dadurch gekennzeichnet, dass** die elektrische Abschirmung (20) jeweils rohrförmig ist und parallel zu ihrer Achse jeweils einen Luftspalt (21) aufweist.

6. Eingangsteil nach Anspruch 5, **dadurch gekennzeichnet, dass** die rohrförmige elektrische Abschirmung (20) jeweils aus einem rohrförmig gebogenen Blech besteht und jeweils der äusseren seitlichen Gestalt des zugehörigen Sensorbausteins (1) angepasst ist.

7. Eingangsteil nach einem der Ansprüche 4 bis 6, **dadurch gekennzeichnet, dass** die rohrförmige elektrische Abschirmung (20) jeweils Lötfahnen (23) aufweist zwecks ihrer Montage auf die Leiterplatte (10).

8. Eingangsteil nach einem der Ansprüche 4 bis 7, **dadurch gekennzeichnet, dass** die rohrförmige elektrische Abschirmung (20) und das rohrförmige magnetische Joch (4) beide am Bezugspotential, Masse eines in den Sensorbausteinen (1) enthaltenen elektronischen Messystems liegen.

9. Eingangsteil nach einem der Ansprüche 1 bis 8, **dadurch gekennzeichnet, dass** das rohrförmige magnetische Joch (4) und/oder die rohrförmige magnetische Abschirmung (9) jeweils aus einem rohrförmig gebogenen Blech bestehen, dessen Stosskanten schwalbenschwanzförmig ineinandergreifen.

10. Eingangsteil nach einem der Ansprüche 1 bis 9, **dadurch gekennzeichnet, dass** der Steg (13), das rohrförmige magnetische Joch (4) und die rohrförmige magnetische Abschirmung (9) jeweils einen rechteckförmigen Querschnitt besitzen.

11. Eingangsteil nach einem der Ansprüche 4 bis 10, **dadurch gekennzeichnet, dass** das rohrförmige magnetische Joch (4) in die rohrförmige magnetische Abschirmung (9) gesteckt ist und in seiner Endposition auf der elektrischen Abschirmung (20) zentriert und eingerastet angeordnet ist.

12. Eingangsteil nach einem der Ansprüche 1 bis 11, **dadurch gekennzeichnet, dass** die Strompfade (8) jeweils eine aus Kupferprofil bestehende Einfachschlaufe bilden.

13. Eingangsteil nach einem der Ansprüche 1 bis 11, **dadurch gekennzeichnet, dass** die Strompfade (8) jeweils eine aus Profildraht oder Runddraht bestehende Mehrfachschlaufe bilden.

14. Eingangsteil nach Anspruch 13, **dadurch gekennzeichnet, dass** die Mehrfachschlaufe aus mehreren annähernd parallelen Windungen besteht.

## Claims

1. An input portion of a measuring apparatus comprising at least one sensor component (1) which is arranged on a circuit board (10) and which is respectively arranged between conductor portions (6, 7) of an associated current path (8), wherein the sensor component (1) together with the conductor portions (6, 7) are at least partially surrounded by an associated tubular magnetic yoke (4) which forms yokes and outer limbs of an associated magnetic circuit (3; 4) and in turn is optionally respectively surrounded by an associated tubular magnetic screening (9), while a central leg (3) of the magnetic circuit (3; 4) is respectively contained in the associated sensor component (1) and has at least one air gap (5) in which an associated sensor (2) is arranged, **characterised in that** a plastics carrier (12) has per current path (8) a leg (13) which has both two duct-shaped passages (14, 15) for the conductor portions (6 and 7 respectively) of the current path (8) in question and also an opening (16) for the sensor component (1) associated with the current path (8) in question, which, extending perpendicularly to the two duct-shaped passages (14, 15), is arranged between the latter in the associated leg (13), that the plastics carrier (12) and at least one current path (8) passing through the duct-shaped passages (14, 15) of the associated leg (13) forms a structural unit, that the circuit board (10) is so arranged that the sensor component (1) is respectively disposed in the opening (16) associated therewith, that the tubular magnetic yoke (4) and, if present, the tubular magnetic screening (9) respectively surrounding same, are pushed on the outside respectively over the associated leg (13) in parallel relationship with the duct-shaped passages (14, 15) in such a way that they laterally embrace at least electromagnetically sensitive portions as well as the central leg (3) and the sensor (2) of the associated sensor component (1), wherein the tubular magnetic yoke (4) and, if present, the tubular magnetic screening (9) are respectively partially disposed between the circuit board (10) and the plastics carrier (12).

2. An input portion according to claim 1 **characterised in that**, if there are a plurality of sensor components (1), they are arranged on a single circuit board (10) and the plastics carrier (12) has such an arrangement (12a; 12b; 12c) for snapping on and for supporting the single circuit board (10) that the latter after it has been snapped on to the plastics carrier (12) is arranged parallel to a surface (26) thereof.

3. An input portion according to claim 1 or claim 2 **characterised in that** the plastics carrier (12) and the circuit board (10) are designed for a maximum number of current paths (8) or sensor components (1) and that if fewer current paths (8) and thus also fewer sensor components (1) than the maximum number are required for embodying the measuring apparatus the passages (14, 15) of the plastics carrier (12), which are associated with the current paths (8) that are not required, are nonetheless occupied with a respective current path (8) that is not required and the assembly locations of the circuit board (10) which are associated with the sensor components (1) that are not required are empty.

4. An input portion according to one of claims 1 to 3 **characterised in that** the sensor component (1) is respectively laterally surrounded by an associated electrical screening (20).

5. An input portion according to claim 4 **characterised in that** the electrical screening (20) is tubular in each case and has a respective air gap (21) parallel to its axis.

6. An input portion according to claim 5 **characterised in that** the tubular electrical screening (20) respectively comprises a tubularly bent metal plate and is respectively adapted to the external lateral configuration of the associated sensor component (1).

7. An input portion according to one of claims 4 to 6 **characterised in that** the tubular electrical screening (20) respectively has soldering lugs (23) for mounting thereof on the circuit board (10).

8. An input portion according to one of claims 4 to 7 **characterised in that** the tubular electrical screening (20) and the tubular magnetic yoke (4) are both at the reference potential, earth, of an electronic measuring system contained in the sensor components (1).

9. An input portion according to one of claims 1 to 8 **characterised in that** the tubular magnetic yoke (4) and/or the tubular magnetic screening (9) respectively comprise a tubularly bent metal plate whose junction edges engage into each other in a dovetail shape.

10. An input portion according to one of claims 1 to 9 **characterised in that** the leg (13), the tubular magnetic yoke (4) and the tubular magnetic screening (9) are each of a rectangular cross-section.

11. An input portion according to one of claims 4 to 10 **characterised in that** the tubular magnetic yoke (4) is fitted into the tubular magnetic screening (9) and arranged in latched and centered relationship in its end position on the electrical screening (20).

12. An input portion according to one of claims 1 to 11 **characterised in that** the current paths (8) respectively form a single loop comprising copper profile.

13. An input portion according to one of claims 1 to 11 **characterised in that** the current paths (8) respectively form a multiple loop comprising profile wire or round wire.

14. An input portion according to claim 13 **characterised in that** the multiple loop comprises a plurality of approximately parallel windings.

## Revendications

1. Circuit d'entrée d'un appareil de mesure comportant au moins un module détecteur (1) qui est disposé sur une carte de circuits imprimés (10) et qui est respectivement disposé entre des parties conductrices (6, 7) d'un circuit de courant correspondant (8), dans lequel le module détecteur (1) ainsi que les parties conductrices (6, 7) sont entourés, au moins partiellement, par une culasse magnétique tubulaire correspondante (4) qui forme des culasses et des branches extérieures d'un circuit magnétique correspondant (3 ; 4) et qui de son côté est, facultativement et respectivement, entouré par un écran magnétique tubulaire correspondant (9), tandis qu'une traverse médiane (3) du circuit magnétique (3 ; 4) est chaque fois contenue dans le module détecteur correspondant (1) et présente au moins un entrefer (5) dans lequel est disposé un détecteur correspondant (2), **caractérisé par le fait qu'**un support en plastique (12) possède, par circuit de courant (8), une traverse (13) qui présente aussi bien deux passages en forme de canaux (14, 15) pour les parties conductrices (6 ou 7) du circuit de courant en question (8) que, pour le module détecteur (1) appartenant au circuit de courant en question (8), un évidement (16) qui, orienté perpendiculairement aux deux passages en forme de canaux (14, 15), est disposé entre ces derniers dans la traverse correspondante (13), que le support en plastique (12) et au moins un circuit de courant (8) qui passe à travers les passages en forme de canaux (14, 15) de la traverse correspondante (13) forment un sous-ensemble, que la carte de circuits imprimés (10) est disposée de façon que le module détecteur (1) se situe chaque fois dans l'évidement (16) qui lui correspond, que la culasse magnétique tubulaire (4) et, s'il y a lieu, l'écran magnétique tubulaire (9) qui l'entoure chaque fois, sont, chacun, enfilés extérieurement au-dessus de la traverse correspondante (13), parallèlement aux passages en forme de canaux (14, 15), de façon qu'ils entourent latéralement au moins les parties électromagnétiquement sensibles ainsi que la traverse médiane (3) et le détecteur (2) du module détecteur correspondant (1), la culasse magnétique tubulaire (4) et, s'il y a lieu, l'écran magnétique tubulaire (9), se situant chacun partiellement entre la carte de circuits imprimés (10) et le support en plastique (12).

2. Circuit d'entrée selon la revendication 1, **caractérisé par le fait que**, dans le cas où il y a plusieurs modules détecteurs (1), ceux-ci sont disposés sur une unique carte de circuits imprimés (10) et que le support en plastique (12) présente, pour encliqueter et poser l'unique carte de circuits imprimés (10), une disposition (12a ; 12b ; 12c) telle qu'après son encliquetage sur le support en plastique (12), cette carte est disposée parallèlement à une surface (26) de ce support.

3. Circuit d'entrée selon la revendication 1 ou 2, **caractérisé par le fait que** le support en plastique (12) et la carte de circuits imprimés (10) sont conçus pour un nombre maximal de circuits de courant (8) ou de modules détecteur (1) et que, si, pour la réalisation de l'appareil de mesure, il faut moins de circuits de courant (8), et donc également moins de modules détecteurs (1) que le nombre maximal, les passages (14, 15) du support en plastique (12) appartenant aux circuits de courant (8) non nécessaires, sont néanmoins occupés par un circuit de courant (8) non nécessaire et que les positions de montage de la carte de circuits imprimés (10) appartenant aux modules détecteurs (1) non nécessaires sont vides.

4. Circuit d'entrée selon l'une des revendications 1 à 3, **caractérisé par le fait que** le module détecteur (1) est respectivement entouré latéralement d'un écran électrique correspondant (20).

5. Circuit d'entrée selon la revendication 4, **caractérisé par le fait que** l'écran électrique (20) est respectivement de forme tubulaire et présente respectivement un entrefer (21) parallèlement à son axe.

6. Circuit d'entrée selon la revendication 5, **caractérisé par le fait que** l'écran électrique tubulaire (20) est respectivement constitué d'une tôle cintrée en forme de tube et qu'il est respectivement adapté à la forme latérale extérieure du module détecteur correspondant (1).

7. Circuit d'entrée selon l'une des revendications 4 à 6, **caractérisé par le fait que** l'écran électrique tubulaire (20) présente respectivement des pattes à souder (23) pour son montage sur la carte de circuits imprimés (10).

8. Circuit d'entrée selon l'une des revendications 4 à 7, **caractérisé par le fait que** l'écran électrique tubulaire (20) et la culasse magnétique tubulaire (4) sont l'un et l'autre au potentiel de référence, masse, d'un système de mesure électronique contenu dans le module détecteur (1).

9. Circuit d'entrée selon l'une des revendications 1 à 8, **caractérisé par le fait que** la culasse magnétique tubulaire (4) et/ou l'écran magnétique tubulaire (9) sont respectivement constitués d'une tôle cintrée en forme de tube dont les bords du joint viennent en prise l'un dans l'autre en queue d'aronde.

10. Circuit d'entrée selon l'une des revendications 1 à 9, **caractérisé par le fait que** la traverse (13), la culasse magnétique tubulaire (4) et l'écran magnétique tubulaire (9) présentent chacun une section rectangulaire.

11. Circuit d'entrée selon l'une des revendications 4 à 10, **caractérisé par le fait que** la culasse magnétique tubulaire (4) est enfichée dans l'écran magnétique tubulaire (9) et que, dans sa position finale, elle est disposée centrée et encliquetée sur l'écran électrique (20).

12. Circuit d'entrée selon l'une des revendications 1 à 11, **caractérisé par le fait que** les circuits de courant (8) forment chacun une boucle simple constituée d'un profilé de cuivre.

13. Circuit d'entrée selon l'une des revendications 1 à 11, **caractérisé par le fait que** les circuits de courant (8) forment chacun une boucle multiple constituée d'un fil profilé ou d'un fil rond.

14. Circuit d'entrée selon la revendication 13, **caractérisé par le fait que** la boucle multiple est constituée de plusieurs spires approximativement parallèles.
